# EUROPÄISCHE PATENTSCHRIFT

(11) **EP 0 287 770 B1**
(45) Veröffentlichungstag und Bekanntmachung des Hinweises auf die Patenterteilung: **05.05.1993**
(21) Anmeldenummer: 88102495.4
(22) Anmeldetag: 20.02.1988
(51) Int. Cl.: H01L 23/04, H01L 23/48

(54) **Halbleiterbauelement mit einer Steuerelektrode**
Semiconductor component having a control electrode
Composant semi-conducteur comprenant une électrode de commande

(30) Priorität: 25.03.1987 CH 1138/87
(43) Veröffentlichungstag der Anmeldung: 26.10.1988
(73) Patentinhaber: BBC Brown Boveri AG, CH-5401 Baden (CH)
(72) Erfinder: Almenräder, Peter, CH-5603 Staufen (CH); Dlouhy, Jiri, CH-5506 Mägenwil (CH); Fingerle, Jürg, CH-5706 Boniswil (CH); Kuhn, Otto, CH-5242 Lupfig (CH)

(56) Entgegenhaltungen:
- EP-A- 0 158 749
- GB-A- 2 162 366
- US-A- 3 837 000
- US-A- 4 263 607
- PATENT ABSTRACTS OF JAPAN, Band 10, Nr. 224 (E-425)[2280], 5. August 1986; & JP-A-61 59 742
- Idem

## Beschreibung

### Technisches Gebiet

Die Erfindung betrifft ein Halbleiterbauelement, umfassend ein Halbleitersubstrat, welches auf einer Hauptfläche einen Kontaktbereich für eine Hauptelektrode und einen Kontaktbereich für eine Steuerelektrode aufweist, eine Hauptelektrode und eine Steuerelektrode, welche das Halbleitersubstrat kontaktieren, wobei die Hauptelektrode eine Nut aufweist, in welcher die Steuerelektrode und eine Feder, welche die Steuerelektrode auf das Halbleitersubstrat presst, untergebracht sind, und eine Steuerelektrodenzugriffsleitung.

### Stand der Technik

Eine Anzahl von steuerbaren Halbleiterbauelementen für höhere Leistung zeichnen sich dadurch aus, dass an der Steuerelektrode kurzzeitig hohe Ströme auftreten. Zu diesen Elementen zählt z.B. der Gate-Ausschaltthyristor (GTO), bei welchem die hohen Ströme zum Ausschalten des Elements erforderlich sind. Damit solche Halbleiterbauelemente einwandfrei funktionieren, ist es wichtig, dass der ganze Gate-Bereich des Halbleitersubstrats verzögerungsfrei und gleichmässig mit Strom versorgt wird. In der Vergangenheit hat sich gezeigt, dass sich das am ehesten mit einer ringförmig ausgebildeten Steuerelektrode realisieren lässt.

Nun geht es darum, eine Anordnung zu finden, bei welcher sich die sich auf derselben Hauptfläche des Halbleitersubstrats befindenden Kontaktbereiche für Haupt- und Steuerelektrode an Haupt- und Steuerelektrode exakt anschliessen lassen.

Eine solche mögliche Anordnung wird in der DE-A1-35 38 815 offenbart. Das entsprechende Bauelement wird wie folgt beschrieben:

Eine rundes Halbleitersubstrat besitzt auf einer Hauptfläche einen Kontaktbereich für eine Hauptelektrode und einen solchen für eine Steuerelektrode. Der Kontaktbereich für die Steuerelektrode ist ringförmig, sodass derjenige für die Hauptelektrode in zwei getrennte Gebiete (einen Kreis und einen umschliessenden Ring) aufgeteilt wird. Die Hauptelektrode ist eine runde Platte, welche auf der dem Halbleitersubstrat zugewandten Seite eine ringförmige Nut aufweist, worin die ringförmige Steuerelektrode untergebracht wird. Die Steuerelektrode ist in der Nut in vertikaler Richtung verschiebbar und wird durch eine ebenfalls in der Nut untergebrachte Spiralfeder mit dem Halbleitersubstrat in Kontakt gehalten.

Als Isolation zwischen Steuer- und Hauptelektrode dient ein auf der Steuerelektrode aufgebrachter Kunststoffilm aus fluoriertem Kunststoff. Die dem Halbleitersubstrat zugewandte Seite der Steuerelektrode ist vom Kunststoffilm ausgespart und zwecks Verbesserung des ohmschen Kontaktes mit Silber beschichtet.

Der Zugriff auf die Steuerelektrode geschieht über einen Leitungsdraht. Zwischen der Hauptelektrode und dem Halbleitersubstrat befindet sich eine Verstärkungsplatte aus Molybdän, welche auch zur Verminderung von Temperaturspannungen im Halbleitersubstrat dient.

Die Herstellung der Steuerelektrode geht wie folgt vor sich. Man nimmt einen Metallring (z.B. aus Kupfer) der gewünschten Abmessung und Toleranz, maskiert die Oberfläche so, dass die Kontaktfläche zum Halbleitersubstrat und die Anschlussstelle für den Leitungsdraht gebildet werden können und spritzt den gewünschten Kunststoff aus, welcher den Isolationsfilm zur Hauptelektrode bildet. Der Leitungsdraht wird an der dafür vorgesehenen Stelle an der Steuerelektrode angelötet. Die kunststofffreie Oberfläche zum Halbleitersubstrat wird mit Silber beschichtet und getempert.

Das Problem des eben beschriebenen, in DE-A1-35 38 815 offengelegten Halbleiterbauelements liegt in seiner ungenügenden mechanischen Robustheit und in seiner aufwendigen Herstellung. In besonderer Weise trifft das für die Steuerelektrode zu. Die Beschichtung mit Kunststoff erweist sich in der Praxis als heikel. Einerseits wird die Wahl des Kunststoffes dadurch eingeschränkt, dass er gut auf der metallenen Oberfläche der Steuerelektrode haften soll, andererseits ist eine gleichmässige, rissfreie Filmbildung nicht leicht zu erreichen. Ferner ist die Maskiertechnik stets mit beträchtlichem Aufwand verbunden.

### Darstellung der Erfindung

Der Erfindung liegt die Aufgabe zugrunde, ein Halbleiterbauelement gemäss Oberbegriff des Patentanspruchs 1 so weiterzubilden, dass die Steuerelektrode leicht und genau positioniert werden kann, mit dem Halbleitersubstrat in gleichmässig verteiltem Druckkontakt gehalten und auf einfache und zuverlässige Weise von der Hauptelektrode isoliert wird.

Die Lösung der gestellten Aufgabe ist dem kennzeichnenden Teil des Patentanspruchs 1 zu entnehmen.

Aus den Unteransprüchen ergeben sich vorteilhafte Ausführungsformen der erfindungsgemässen Anordnung.

Ein erfindungsgemässes Halbleiterbauelement umfasst ein rundes Halbleitersubstrat , welches
auf einer Hauptfläche einen Kontaktbereich für eine Hauptelektrode und einen zentralsymmetrischen Kontaktbereich für eine Steuerelektrode aufweist, eine Hauptelektrode und
eine Steuerelektrode , welche das Halbleitersubstrat kontaktieren,
wobei die Hauptelektrode eine ringförmige Nut ausweist,
in welcher die Steuerelektrode
eine Feder , welche die Steuerelektrode auf das Halbleitersubstrat presst, und
ein eingesetzter, u-förmiger Isolationskörper welcher die Nut der Hauptelektrode mantelartig ausfüllt und die Steuerelektrode von der Hauptelektrode isoliert, untergebracht sind,
wobei der Isolationskörper mit den Enden des u-förmigen Profils aus der Nut herausragt, und
eine Steuerelektrodenzugriffsleitung ; worin
der Isolationskörper aus temperaturbeständigem Kunststoff, insbesondere thermoplastischem Kunststoff besteht,
die Feder , welche die Steuerelektrode auf das Halbleitersubstrat presst, eine Mäanderfeder ist.

Die Verwendung eines selbständigen Isolationskörpers gibt eine grosse Freiheit bei der Wahl dessen Materials. Es ist nicht mehr nötig, sich auf Kunststoffe zu beschränken, welche an der metallenen Steuerelektrode gut haften. Ausserdem vereinfacht sich die Herstellung der Steuerelektrode beträchtlich, da auf Maskierverfahren vollständig verzichtet werden kann.

In einer bevorzugten Ausführungsform der Erfindung weist der Isolationskörper ein u-förmiges Profil auf, sodass er die Nut mantelartig auskleidet und mit den beiden Enden des Profils aus der Nut herausragt. Dies erlaubt es, Molybdänscheiben, welche als Verstärkungsplatten zwischen Hauptelektrode und Halbleitersubstrat eingeschoben werden können, einfach und genau zu positionieren.

### Kurze Beschriebung der Zeichnungen

Nachfolgend wird die Erfindung anhand eines vorteilhaften Ausführungsbeispiels erläutert, wobei auf die Figuren 1-3 Bezug genommen wird.

Es zeigen:
- Fig. 1: eine perspektivische Darstellung eines Halbleitersubstrats mit einer ringförmigen Steuerelektrode, entsprechend dem Stand der Technik;
- Fig. 2: einen axialen Querschnitt durch ein Ausführungsbeispiel eines erfindungsgemässen Halbleiterbauelements;
- Fig. 3a: einen Schnitt durch eine ringförmige Mäanderfeder; und
- Fig. 3b: eine Draufsicht auf die Mäanderfeder.

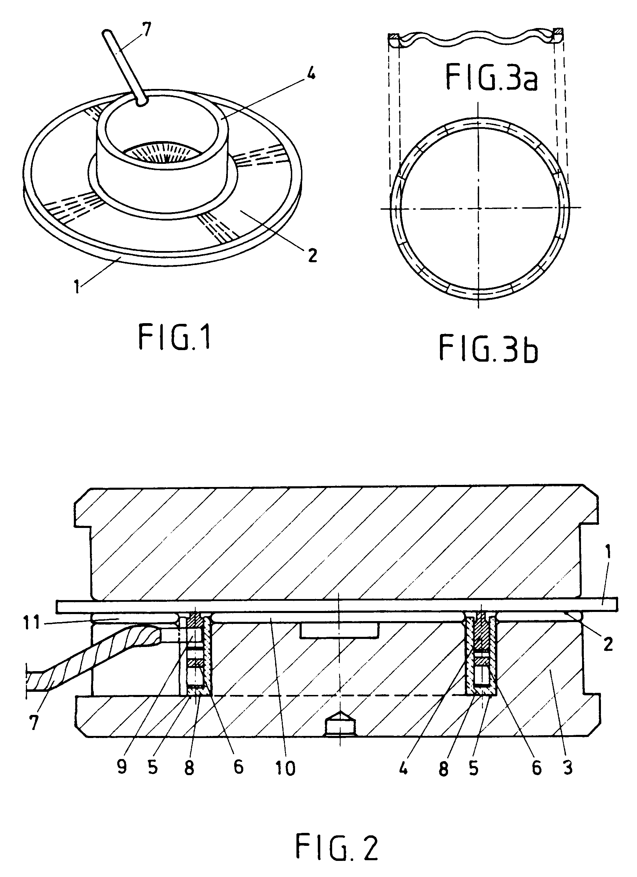

In Fig. 1 ist ein rundes Halbleitersubstrat 1 dargestellt, in welchem ein Gate-Ausschaltthyristor auf herkömmliche Art eingebracht worden ist. Dieses, dem Stand der Technik entsprechende Halbleitersubstrat 1 weist auf einer Hauptfläche 2 einen Kathodenbereich und einen Gate-Bereich auf, welche in bekannter Weise fingerartig ineinander greifen. Der Gate-Bereich wird durch eine ebenfalls bekannte ringförmige Steuerelektrode 4 kontaktiert. In Fig. 1 ist ferner eine Steuerelektrodenzugriffsleitung 7 angedeutet.

Ausgehend von dieser, zum Stand der Technik gehörenden Anordnung soll in einem Ausführungsbeispiel die Erfindung erläutert werden.

Fig. 2 zeigt einen Achsenschnitt durch das Ausführungsbeispiel, wobei die eben beschriebenen Elemente in gleicher Weise bezeichnet sind.

Als Hauptelektrode 3 dient eine runde Metallplatte, welche eine geeignet gestaltete, ringförmige Nut 5 aufweist. In die Nut 5 wird ein Isolationskörper 8 eingeschoben, welcher ein u-förmiges Profil besitzt und so die Nut 5 mantelartig auskleidet, wobei der nun noch zur Verfügung stehende Teil der Nut 5 etwas kleiner geworden, aber in seiner Form im wesentlichen erhalten geblieben ist. In die mit dem Isolationskörper 8 ausgestattete Nut 5 wird eine ringförmige Feder 6 eingeschoben, gefolgt von der ringförmigen Steuerelektrode 4, welche so bemessen ist, dass sie den Isolationskörper 8 mit ihren beiden Seitenflächen leicht berührt, wodurch ihre Lage relativ zur Hauptelektrode 3, und damit auch zum Halbleitersubstrat 1, in horizontaler Richtung exakt bestimmt ist, dass sie aber trotzdem in vertikaler Richtung frei verschiebbar ist, sodass sie von der Feder 6 auf das Halbleitersubstrat 1 gepresst werden kann.

An einer dafür vorgesehenen Kontaktstelle 9 wird die Steuerelektrode galvanisch an eine Steuerelektrodenzugriffsleitung 7 angeschlossen. Bevorzugterweise wird als Steuerelektrodenzugriffsleitung 7 eine Litze verwendet, damit eine unnötige, mechanische Belastung der beispielsweise hartgelöteten Kontaktstelle 9 vermieden werden kann. Um einen optimalen Kontakt zwischen der Steuerelektrode 4 und dem Halbleitersubstrat 1 zu erreichen, wird die Oberfläche der Steuerelektrode 4 nachträglich mit einer gutleitenden Schicht versehen. Besteht die Steuerelektrode beispielsweise aus Kupfermaterial, so wird sie vorzugsweise mit Gold beschichtet.

Der Isolationskörper 8 besteht vorzugsweise aus temperaturbeständigem Kunststoff (z.B. aus dem thermoplastischem Polymergranulat Ryton von der Firma Philips Petroleum) und kann beispielsweise durch Ausspritzen einer Spritzgussform hergestellt werden. Die Wandstärke desselben soll so gewählt werden, dass sie der mechanischen Beanspruchung während der Montage problemlos widersteht. Bei einem bewährten Ausführungsbeispiel wurde eine Stärke von 0,8 mm gewählt.

In einer bevorzugten Ausführung wird als Feder 6 eine sogenannte Mäanderfeder benützt (Fig. 3a/3b). Diese ist ein Ring, welcher sich wellenförmig von einer ebenen Unterlage abhebt. Eine solche Mäanderfeder kann z.B. aus rostfreiem Federstahl oder aus Be-Cu auf einfache Art hergestellt werden. Ihr Vorteil liegt darin, dass sie sehr wenig Raum beansprucht. Ausserdem verteilt sie den auftretenden Druck wegen ihrer mit steigender Belastung wachsenden Federkonstanten automatisch gleichmässig auf ihre Auflagepunkte.

In einer weiteren, bevorzugten Ausführung des Erfindungsgegenstandes wird der Isolationskörper 8 so bemessen, dass er mit den beiden Enden seines u-förmigen Profils ein wenig aus der Nut 5 herausragt (Fig. 2). An diesen, über die Oberfläche der Hauptelektrode 3 herausragenden, konzentrischen Rändern lassen sich auf einfache Art eine innere, kreisförmige und eine äussere, ringförmige Verstärkungsplatte (10/11) ausrichten, vorausgesetzt, sie sind mit der nötigen Genauigkeit hergestellt.

Um die bei Gate-Ausschaltthyristoren wichtige, genaue Positionierung der ringförmigen Steuerelektrode in Bezug auf den Gate-Bereich des Halbleiter-Substrats zu erreichen, müssen Nut, Isolationskörper und Steuerelektrode präzis aufeinander abgestimmt sein, damit keine unerwünschten, horizontalen Verschiebungen der Steuerelektrode während der Montage auftreten können.

Während beim Stand der Technik die Steuerelektrode geeignet maskiert werden muss, um Isolationsfilm und Kontaktschicht anbringen zu können, entfallen solch aufwendige Verfahrensschritte bei der Herstellung des erfindungsgemässen Halbleiterbauelements.

Das Ausführungsbeispiel bezieht sich auf die Kontaktierung eines Halbleitersubstrats für einen Gate-Ausschaltthyristor mit ringförmiger Steuerelektrode, was aber nicht heisst, dass sich der Erfindungsgedanke nur auf derart geformte Steuerelektroden oder nur auf Gate-Ausschaltthyristoren beschränkt. Vielmehr lässt er sich auf beliebig geformte Steuerelektroden solcher Halbleiterbauelemente anwenden, bei welchen eine Steuerelektrode in einer Nut einer Hauptelektrode untergebracht werden kann. Weiter lässt sich die Erfindung ohne Einschränkung auf Bauelemente anwenden, bei welchen unter einer Hauptelektrode mehrere Steuerelektroden angeordnet sind.

Abschliessend kann gesagt werden, dass mit der Erfindung ein Halbleiterbauelement zur Verfügung steht, welches einen robusten Aufbau hat und zudem einfach mit der benötigten Präzision hergestellt werden kann.

## Patentansprüche

1. Leistungshalbleiterbauelement, insbesondere ein GTO (Gate-Turn-Off-Thyristor), umfassend
a) ein rundes Halbleitersubstrat (1), welches
b) auf einer Hauptfläche (2) einen Kontaktbereich für eine Hauptelektrode (3) und einen zentralsymmetrischen Kontaktbereich für eine Steuerelektrode (4) aufweist,
c) eine Hauptelektrode (3) und
d) eine Steuerelektrode (4), welche das Halbleitersubstrat (1) kontaktieren,
e) wobei die Hauptelektrode (3) eine ringförmige Nut (5) aufweist,
f) in welcher die Steuerelektrode (4),
g) eine Feder (6), welche die Steuerelektrode (4) auf das Halbleitersubstrat (1) presst, und
h) ein eingesetzter, u-förmiger Isolationskörper (8), welcher die Nut (5) der Hauptelektrode (3) mantelartig auskleidet und die Steuerelektrode (4) von der Hauptelektrode (3) isoliert, untergebracht sind,
i) wobei der Isolationskörper (8) mit den Enden des u-förmigen Profils aus der Nut (5) herausragt, und
k) eine Steuerelektrodenzugriffsleitung (7);
dadurch gekennzeichnet, dass
l) der Isolationskörper (8) aus temperaturbeständigem Kunststoff, insbesondere thermoplastischem Kunststoff besteht,
m) die Feder (6), welche die Steuerelektrode (4) auf das Halbleitersubstrat (1) presst, eine Mäanderfeder ist.

2. Leistungshalbleiterbauelement nach Anspruch 1, dadurch gekennzeichnet, dass die Mäanderfeder (6) aus rostfreiem Federstahl oder aus Be-Cu besteht.

3. Leistungshalbleiterbauelement nach Anspruch 1, dadurch gekennzeichnet, dass als Steuerelektrodenzugriffsleitung (7) eine Litze verwendet wird, welche mit der Steuerelektrode (4) durch Hartlöten verbunden ist.

4. Leistungshalbleiterbauelement nach Anspruch 1, dadurch gekennzeichnet, dass die Oberfläche der Steuerelektrode (4) mit einer leitfähigen Schicht versehen ist, insbesondere, dass sie vergoldet ist.

## Claims

1. Power semiconductor component, especially a GTO (Gate Turn Off thyristor), comprising
a) a round semiconductor substrate (1), which
b) exhibits on a main surface (2) a contact area for a main electrode (3) and a centrally symmetric contact area for a control electrode (4),
c) a main electrode (3) and
d) a control electrode (4), which are in contact with the semiconductor substrate (1),
e) in which arrangement the main electrode (3) exhibits an annular groove (5),
f) in which the control electrode (4),
g) a spring (6), which presses the control electrode (4) against the semiconductor substrate (1), and
h) an inserted U-shaped insulation body (8), which lines the groove (5) of the main electrode (3) in the manner of a jacket and insulates the control electrode (4) against the main electrode (3) are accommodated,
i) the insulation body (8) projecting from the groove (5) with the ends of the U-shaped section, and
k) a control electrode access line (7); characterised in that
l) the insulation body (8) consists of heat-resistant plastic, particularly of thermoplastic,
m) the spring (6), which presses the control electrode (4) onto the semiconductor substrate (1), is an ondular spring.

2. Power semiconductor component according to Claim 1, characterised in that the ondular spring (6) consists of stainless spring steel or of BeCu.

3. Power semiconductor component according to Claim 1, characterised in that a litz wire is used as control electrode access line (7) which is connected to the control electrode (4) by hard soldering.

4. Power semiconductor component according to Claim 1, characterised in that the surface of the control electrode (4) is provided with a conductive layer and, in particular, is gold-plated.

## Revendications

1. Composant semiconducteur de puissance, en particulier un GTO (Gate-Turn-Off Thyristor = thyristor interruptible), comprenant
a) un support de semiconducteur de forme ronde (1), qui
b) présente sur une face principale (2) une zone de contact pour une électrode principale (3) et une zone de contact à symétrie centrale pour une électrode de commande (4),
c) une électrode principale (3) et
d) une électrode de commande (4), qui sont en contact avec le support de semiconducteur (1),
e) dans lequel l'électrode principale (3) présente une gorge circulaire (5),
f) dans laquelle sont disposés l'électrode de commande (4),
g) un ressort (6), qui presse l'électrode de commande (4) sur le support de semiconducteur (1), et
h) un corps d'isolation (8) rapporté, en forme de U, qui garnit intérieurement la gorge (5) de l'électrode principale (3) et qui isole l'électrode de commande (4) de l'électrode principale (3),
i) dans lequel le corps d'isolation (8) se prolonge hors de la gorge (5) par les extrémités du profil en forme de U, et
k) une ligne (7) d'accès à l'électrode de commande;
caractérisé en ce que
l) le corps d'isolation (8) est réalisé en une matière plastique résistant à la température, en particulier d'une matière plastique thermoplastique, et en ce que
m) le ressort (6), qui presse l'électrode de commande (4) sur le support de semiconducteur (1), est un ressort sinueux.

2. Composant semiconducteur de puissance suivant la revendication 1, caractérisé en ce que le ressort sinueux (6) est réalisé en acier inoxydable à ressort ou en Be-Cu.

3. Composant semiconducteur de puissance suivant la revendication 1, caractérisé en ce que l'on utilise, en guise de ligne (7) d'accès à l'électrode de commande, une tresse qui est attachée à l'électrode de commande (4) par brasage fort.

4. Composant semiconducteur de puissance suivant la revendication 1, caractérisé en ce que la surface de l'électrode de commande (4) est pourvue d'une couche conductrice, en particulier en ce qu'elle est revêtue d'or.
